(19) Europäisches Patentamt
European Patent Office
Office européen des brevets

(11) Veröffentlichungsnummer: **0 414 104 A2**

(12) **EUROPÄISCHE PATENTANMELDUNG**

(21) Anmeldenummer: **90115568.9**

(51) Int. Cl.5: **G03F 7/027**

(22) Anmeldetag: **14.08.90**

(30) Priorität: **22.08.89 DE 3927628**

(43) Veröffentlichungstag der Anmeldung: **27.02.91 Patentblatt 91/09**

(84) Benannte Vertragsstaaten: **AT BE CH DE DK ES FR GB IT LI NL SE**

(71) Anmelder: **BASF Aktiengesellschaft**
**Carl-Bosch-Strasse 38**
**D-6700 Ludwigshafen(DE)**

(72) Erfinder: **Seitz, Friedrich, Dr.**
**Von-Wieser-Strasse 1**
**D-6701 Friedelsheim(DE)**
Erfinder: **Beck, Erich, Dr.**
**Konrad-Adenauer-Strasse 15**
**D-6721 Harthausen(DE)**
Erfinder: **Roser, Joachim, Dr.**
**Saarlandstrasse 40**
**D-6700 Ludwigshafen(DE)**
Erfinder: **Bueschges, Elenore, Dr.**
**Schauinslandstrasse 9**
**D-6800 Mannheim 1(DE)**
Erfinder: **Schulz, Guenther, Dr.**
**Im Roehrich 45**
**D-6702 Bad Duerkheim(DE)**
Erfinder: **Zwez, Thomas, Dr.**
**Allmendstrasse 8**
**D-7500 Karlsruhe 51(DE)**

(54) **Strahlungsempfindliches Gemisch.**

(57) Die Erfindung betrifft ein strahlungsempfindliches Gemisch aus
(a) einem Harnstoffgruppen enthaltenden Umsetzungsprodukt,
(b) mindestens einer eine oder mehrere Carboxylgruppen enthaltenden organischen Verbindung,
(c) mindestens einer ein- oder mehrfach ethylenisch ungesättigten organischen Verbindung,
(d) gegebenenfalls einem Photoinitiator oder Photoinitiatorsystem,
sowie
(e) gegebenenfalls weiteren Hilfs- und Zusatzstoffen, wobei als Komponente (a) ein Umsetzungsprodukt aus
i) mindestens einem Di- oder Polyisocyanat,
ii) mindestens einer organischen Verbindung mit mindestens einer primären oder sekundären Aminogruppe und
iii) gegebenenfalls einer oder mehreren Verbindungen mit mindestens einer Hydroxylgruppe, eingesetzt wird.

EP 0 414 104 A2

## STRAHLUNGSEMPFINDLICHES GEMISCH

Die Erfindung betrifft ein strahlungsempfindliches Gemisch aus einem Harnstoffgruppen enthaltenden Umsetzungsprodukt, einer Carboxylgruppen enthaltenden Verbindung und einer ethylenisch ungesättigten Verbindung. Die Erfindung betrifft insbesondere solche strahlungsempfindlichen Gemische, deren Löslichkeit in wasser oder wäßrig-alkalischer Lösung bei Bestrahlung zunimmt.

Positiv arbeitende lichtempfindliche Zusammensetzungen, d.h. Verbindungen oder Gemische von Verbindungen, deren Löslichkeit in einem vorgegebenen Lösungsmittel bei Bestrahlung zunimmt, sind an sich bekannt. Die in der Reproduktionstechnik am häufigsten eingesetzten Verbindungen sind Naphthochinondiazide oder deren Derivate (vgl. W. Fraß, Chemie in unserer Zeit, 17 (1983) 10; H. W. Vollmann, Angew. Chem. 92 (1980) 95). Bei Bestrahlung dieser Verbindungen wird über Stickstoffabspaltung und Wolff-Umlagerung aus einer hydrophoben Diazoketon-Einheit eine Carboxylgruppe gebildet, die die genannten Verbindungen bzw. die aus diesen Verbindungen hergestellten Mischungen in wäßrig-alkalischen Lösungen löslich macht.

Eine weitere Verbindungsklasse, die sich zur Herstellung von positiv arbeitenden lichtempfindlichen Gemischen eignet, sind aromatische oder heteroaromatische Nitroverbindungen. Während die oben beschriebenen Verbindungen mit Diazoketon-Struktur in den lichtempfindlichen Gemischen meist als niedermolekulare Verbindungen vorliegen, können als lichtempfindliche Nitroverbindungen sowohl niedermolekulare Verbindungen (DE-A-22 07 574, US-A-4 181 531) als auch Polymere aus Monomeren mit o-Nitrocarbinolester-Struktur bzw. Copolymere dieser Monomeren mit anderen Vinylverbindungen verwendet werden (vgl. DE-A-21 50 691, DE-A-29 22 746 und EP-A-19 770). Auch hier wird bei Bestrahlung eine Carboxylgruppe gebildet, die die Löslichkeit der Gemische in wäßrig-alkalischen Lösungen erhöht.

Auf einem ähnlichen Prinzip dürften die Positivsysteme beruhen, die z. B. in US-A-4 469 774 beschrieben sind und photochemisch spaltbare Benzoinester in der Seitenkette enthalten.

Ein weiteres Verfahren, das auf der Erhöhung der Löslichkeit durch Carboxylgruppen beruht, ist zum Beispiel in EP-A-62 474, EP-A-99 949 oder US-A-4 415 652 beschrieben. Hier wird ein Gemisch aus einem in wäßriger Lösung unlöslichen Bindemittel, einer Mercaptocarbonsäure und einem bei Bestrahlung Radikale bildenden Initiatorsystem beschrieben. Die Bestrah lung führt zu einer radikalischen Pfropfung der Mercaptocarbonsäure auf das Bindemittel, das dadurch in wäßrig-alkalischen Lösungen löslich wird.

Bei photoempfindlichen Mischungen, die nach einem der oben beschriebenen Prinzipien aufgebaut sind, wird pro absorbiertem Lichtquant nur maximal eine Carboxylgruppe erzeugt bzw. auf das Bindemittel gepfropft. Meist liegt die Quantenausbeute noch deutlich unter 1. Daher sind in allen Fällen lange Belichtungszeiten erforderlich, die erreichte Löslichkeitsdifferenzierung ist dennoch meist schlecht. Von den genannten photoempfindlichen Systemen konnten sich daher nur die auf der Basis der Wolff-Umlagerung von Diazoketonen funktionierenden auf dem Markt behaupten, und auch diese nur im Bereich der Positiv-Offset-Platten bzw. der Positivresiste für die Herstellung integrierter Schaltungen. Für andere Produkte, von denen insbesondere Photoresistfilme für die Leiterplattenfertigung genannt seien, sind die erforderlichen langen Belichtungszeiten und die wegen der geringen Löslichkeitsdifferenzierung erforderlichen halbwäßrigen Entwicklerlösungen unakzeptabel. Das Problem der Entsorgung der Entwicklerlösungen wird in Zukunft noch an Bedeutung gewinnen.

Eine prinzipiell andere Möglichkeit, die Löslichkeit einer photoempfindlichen Schicht durch Belichtung zu erhöhen, besteht darin, die Zusammensetzung der Schicht so zu wählen, daß bei Bestrahlung das mittlere Molekulargewicht des Bindemittels abnimmt. Hierzu werden durch aktinisches Licht spaltbare Gruppen in die Hauptkette eines Polymeren eingebaut. Beispiele für solche Systeme sind z. B. Polyoxymethylen-Polymere, die in der Hauptkette Acetaleinheiten, die aus o-Nitrobenzaldehyd oder Derivaten des o-Nitrobenzaldehyds gebildet sind, enthalten. Solche Polymere und aus ihnen hergestellte lichtempfindliche Schichten sind z. B. in US-A-3 991 033 und US-A-4 189 611 beschrieben. Auf ähnliche Weise können Acetale des o-Nitrobenzaldehyds auch in die Hauptkette von Polymeren eingebaut werden, die im wesentlichen einen Polyester aus einer Dicarbonsäure und einem difunktionellen Alkohol darstellen (vgl. US-A-4 086 210). Andere Polymere, die bei Bestrahlung unter Spaltung der Hauptkette und damit einer Verringerung des Molekulargewichts reagieren, sind Polymere, die in ihrer Hauptkette Hexaarylbisimidazoleinheiten enthalten (vgl. US-A-4 009 040).

Als eine Kombination aus Hauptkettenabbau und Pfropfung einer Carboxylgruppe läßt sich das in EP-A-57 162 beschriebene Verfahren verstehen, in dem neben einem Polymeren, das in der Hauptkette Benzoineinheiten enthält, ungesättigte Carbonsäuren vorliegen. Bei Belichtung werden die Benzoineinheiten unter Verringerung des mittleren Molekulargewichts gespalten. Gleichzeitig werden die ungesättigten Carbonsäuren an die an den Spalt stellen entstehenden Radikale addiert und erhöhen so ebenfalls die

Löslichkeit in wäßrig-alkalischer Lösung.

Auch die auf dem Hauptkettenabbau eines geeigneten Polymeren nach einem der oben beschriebenen Prinzipien basierenden positiv arbeitenden photoempfindlichen Schichten weisen nur eine geringe Lichtempfindlichkeit auf. Zudem ist in vielen Fällen nach der Belichtung eine thermische Nachbehandlung nötig. In der Praxis konnte sich daher keines der beschriebenen Verfahren durchsetzen.

Man hat daher versucht, die hohe Lichtempfindlichkeit photopolymerisierbarer Schichten für die Herstellung positiv arbeitender Schichten zu nutzen, indem man durch Belichtung durch eine Vorlage bildmäßig einen Inhibitor der Polymerisation erzeugt und dann in einem zweiten, nicht notwendigerweise bildmäßigen Belichtungsschritt die nicht inhibierten Stellen polymerisiert. Als Verbindungen, aus denen durch Belichtung Polymerisationsinhibitoren erzeugt werden können, wurden z. B. Nitrosodimere (vgl. DE-A-25 42 151) oder gewisse o-Nitroaromaten vorgeschlagen (vgl. DE-A-27 10 417 und EP-A-103 197). Bei diesen Verfahren ist in jedem Fall ein zusätzlicher Belichtungsschritt nötig, so daß die Gesamtprozeßzeit gegenüber anderen Positivsystemen eher erhöht wird.

Der bisher erfolgreichste Versuch, die Lichtempfindlichkeit positiv arbeitender lichtempfindlicher Schichten zu erhöhen, ist unter dem Begriff der chemischen Verstärkung bekannt geworden. Hier wird bei Belichtung ein Katalysator erzeugt, der in einem zweiten, thermischen Verfahrensschritt eine Reaktion beschleunigt, die letztlich zu einer Erhöhung der Löslichkeit der photoempfindlichen Schicht führt. Bei dem Katalysator handelt es sich meist um eine starke Säure, die photochemisch z. B. aus einer organischen Halogenverbindung, vor allem einer halogenhaltigen Triazinverbindung (vgl. z. B. DE-A-23 06 248), einer aromatischen Nitroverbindung (vgl. z. B. EP-A-78 981), einem Diazoniumsalz oder einem aromatischen Iodonium-bzw. Sulfoniumsalz (vgl. z. B. DE-A-36 20 677 und US-A-4 491 628) gebildet wird. Die gebildete Säure wird benutzt, um im zweiten, thermischen Verfahrensschritt säurelabile Bindungen zu spalten. Je nach verwendeter säurelabiler Verbindung kann diese Spaltung entweder die Bildung einer hydrophilen aus einer hydrophoben Gruppe (vgl. z. B. DE-A-36 20 677 und US-A-4 491 628) oder einen Abbau des Molekulargewichts bewirken. Für den letzten Fall geeignete säurelabile Gruppen sind z. B. Acetal- (vgl. DE-A-23 06 248, EP-A-78 981, EP-A-82 463 und US-A-3 779 778), Orthocarbonsäureester- (vgl. EP-A-78 981 und EP-A-82 463), Enolether- (vgl. EP-A-6 627 und EP-A-82 463), Silylether- (vgl. DE-A-35 44 165 und EP-A-130 599) oder Silylestergruppen (vgl. EP-A-130 599). Obwohl mit diesen Gemischen Lichtempfindlichkeiten erreicht werden können, die in günstigen Fällen denen negativ arbeitender Schichten entsprechen, haben Produkte, die nach dem Prinzip der chemischen Verstärkung aufgebaut sind, nur im Bereich der Resiste für die Herstellung integrierter Schaltungen Bedeutung erlangt. In anderen Einsatzgebieten wird der erforderliche zusätzliche thermische Verfahrensschritt nicht akzeptiert.

Ein weiterer Typ eines positiv arbeitenden lichtempfindlichen Gemisches wird in EP-A-106 156 beschrieben. Dieses Gemisch besteht aus einem Polykondensat mit bestimmten Gruppen in der Hauptkette und ungesättigten Gruppen am Kettenende in Kombination mit einem Photoinitiator. Als die Hauptkette aufbauende Gruppen werden aromatische Kohlenwasserstoff-, Diarylether-, Diarylsulfid-, Diarylsulfon-, Diarylamin-, Diarylketon- und Diaryldiketongruppen genannt. Endgruppen sind Alkenylgruppen oder Reste ungesättigter Carbonsäuren. Als Ursache für die Erhöhung der Löslichkeit bei Belichtung wird ein radikalisch induzierter Kettenabbau vermutet. Trotz eines sehr hohen Initiatoranteils von typischerweise 25 Gew.-% werden nur mäßige Lichtempfindlichkeiten erreicht.

Die aufgeführten Beispiele zeigen, daß für die meisten Anwendungszwecke noch immer ein Bedarf an neuen positiv arbeitenden lichtempfindlichen Gemischen besteht, die hohe Lichtempfindlichkeit und einfache Handhabung, d. h. insbesondere keine zusätzlichen Verfahrensschritte, miteinander kombinieren. Aufgabe der vorliegenden Erfindung war es, ein positiv arbeitendes lichtempfindliches Gemisch mit den genannten Eigenschaften zu entwickeln sowie das ihm zugrundeliegende Umsetzungsprodukt aufzuzeigen.

Überraschenderweise wurde gefunden, daß die Löslichkeit von Gemischen aus (a) bestimmten Harnstoffgruppen enthaltenden Umsetzungsprodukten, (b) Verbindungen, die eine oder mehrere Carboxylgruppen enthalten, und (c) ethylenisch ungesättigten Verbindungen, bei Belichtung in Gegenwart von Verbindungen, aus denen bei Belichtung Radikale entstehen, zunimmt.

Gegenstand der vorliegenden Erfindung ist ein strahlungsempfindliches Gemisch aus

(a) einem Harnstoffgruppen enthaltenden Umsetzungsprodukt,

(b) mindestens einer eine oder mehrere Carboxylgruppen enthaltenden organischen Verbindung,

(c) mindestens einer ein- oder mehrfach ethylenisch ungesättigten organischen Verbindung,

(d) gegebenenfalls einem Photoinitiator oder Photoinitiatorsystem,

sowie

(e) gegebenenfalls weiteren Hilfs- und Zusatzstoffen, das dadurch gekennzeichnet ist, daß als Komponente (a) ein Umsetzungsprodukt aus

i) mindestens einem Di- oder Polyisocyanat mit

ii) mindestens einer organischen Verbindung mit mindestens einer primären oder sekundären Aminogruppe und

iii) gegebenenfalls einer oder mehreren Verbindungen mit mindestens einer Hydroxylgruppe, wobei die Anzahl der NCO-Gruppen in Komponente i) kleiner oder gleich der Anzahl der damit reaktiven Gruppen in ii) und iii) ist, eingesetzt wird.

Insbesondere sind solche strahlungsempfindlichen Gemische Gegenstand der Erfindung, deren Löslichkeit in Wasser oder wäßrig-alkalischer Lösung bei Bestrahlung oder Belichtung zunimmt.

Besondere Ausführungsformen der Erfindung bestehen darin, daß man zur Herstellung des erfindungsgemäß einzusetzenden Umsetzungsproduktes (a) als Komponente i) ein Diisocyanat, als Komponente ii) ein oder mehrere primäre und/oder sekundäre Amine der allgemeinen Formel

$R'HN-R-XH$ (I)

wobei

R den zweiwertigen Rest eines, gegebenenfalls substituierten, Alkans, Arens, Ethers, Polyethers, Amins, Polyamins, Esters, Polyesters, Amids oder Polyamids,

$R'$ Wasserstoff, Alkyl, Aryl, Aralkyl, Hydroxyalkyl, Aminoalkyl, Mercaptoalkyl, Derivate derselben oder den einwertigen Rest $H\{O-(CH_2)_n-CHR''\}_m$ mit $n = 1$ bis 3 und $m = 1$ bis 10 oder Isomere desselben und $R''$ = H oder $C_1$- bis $C_4$-Alkyl,

X O, S oder $NR'''$,

$R'''$ Wasserstoff, Alkyl, Aryl, Aralkyl, Hydroxyalkyl, Aminoalkyl, Mercaptoalkyl oder Derivate derselben bedeuten, und/oder

mindestens einer Aminoverbindung der allgemeinen Formel

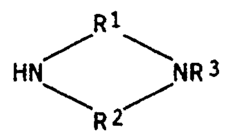 ,

wobei

$R^1$ und $R^2$ untereinander gleich oder verschieden sind und den zweiwertigen Rest eines, gegebenenfalls substituierten, Alkans, Arens, Ethers, Polyethers, Amins, Polyamins, Esters, Polyesters, Amids oder Polyamids bedeuten,

$R^3$ Wasserstoff, Alkyl, Aryl, Aralkyl, Hydroxyalkyl, Aminoalkyl, Mercaptoalkyl oder Derivate derselben bedeutet

oder

eine Kombination aus wenigstens einem dieser Amine und wenigstens einem weiteren davon verschiedenen primären oder sekundären Amin und als Komponente iii) einen aliphatischen Monoalkohol einsetzt. Als Komponente (b) kommen insbesondere Carboxylgruppen enthaltende Verbindungen mit einem mittleren Molekulargewicht $\overline{M}_n$ von über 10.000, und einer Säurezahl zwischen 50 und 300 mg KOH/g in Betracht. Besonders bevorzugt sind Copolymere aus einem sauren Monomeren und mindestens einem hydrophoben Monomeren, wobei als saure Monomere vorzugsweise Acrylsäure, Methacrylsäure, Crotonsäure oder Itaconsäure, als hydrophobes Monomer vorzugsweise Styrole, Acrylate und Methacrylate zu verwenden sind.

Als ein- oder mehrfach ethylenisch ungesättigte Verbindung (c) eignen sich $\alpha,\beta$-ethylenisch ungesättigte Carbonylverbindungen, vorzugsweise Acrylate oder Methacrylate.

Die Komponenten (b) und (c) können auch identisch sein.

Als Komponente (d) sind Benzophenon oder seine Derivate, Hexaarylbisimidazolderivate, N-Alkoxypyridiniumsalze oder Gemische dieser Verbindungen bevorzugt.

Das Harnstoffgruppen enthaltende Umsetzungsprodukt (a) des erfindungsgemäßen strahlungsempfindlichen Gemisches wird durch Umsetzung der Isocyanatkomponente i) mit der Aminkomponente ii) und gegebenenfalls mit der Hydroxykomponente iii) hergestellt, wobei die gegenüber Isocyanat reaktiven Gruppen in äquivalenter Menge oder im Überschuß, bevorzugt in Verhältnissen zwischen 1:1 und 4:1 eingesetzt werden. Die Umsetzung der Komponenten i) bis iii) kann gleichzeitig oder in beliebiger Reihenfolge stufenweise erfolgen.

Diese Reaktion kann lösungsmittelfrei oder auch in inerten Lösungsmitteln z. B. Aceton, Tetrahydrofuran, Dioxan, Dichlormethan, Toluol, Methylethylketon, Essigester, durchgeführt werden. Ebenfalls als Lösungsmittel geeignet sind ein- oder mehrfach ethylenisch ungesättigte Verbindungen, sofern diese flüssig sind.

Die Reaktionstemperatur für die Umsetzung der Isocyanatgruppen liegt im allgemeinen zwischen 0 und 100 °C, vorzugsweise zwischen 20 und 70 °C.

Zur Beschleunigung der Umsetzung können Katalysatoren wie sie z. B. in Houben Weyl, Methoden der organischen Chemie, Bd. XIV/2, S. 60f, Georg Thieme-Verlag, Stuttgart (1963) bzw. Ullmann, Encyclopädie der technischen Chemie, Bd. 19, S. 306 (1981) beschrieben sind, eingesetzt werden. Bevorzugt sind zinnhaltige Verbindungen wie Dibutylzinndilaurat, Zinn(II)-octoat oder Dibutylzinndimethoxid.

Im allgemeinen wird der Katalysator in einer Menge von 0,001 bis 2,5 Gew.-%, bevorzugt von 0,005 bis 1,5 Gew.-%, bezogen auf die Gesamtmenge der Reaktanden eingesetzt.

Bezüglich der Aufbaukomponenten für die Herstellung der Umsetzungsprodukte (a) und für ihren Einsatz in den erfindungsgemäßen strahlungsempfindlichen Gemischen mit den Komponenten (b) bis (d) ist im einzelnen folgendes auszuführen.

Für die Umsetzung der Komponenten i) bis iii) sind als Di- oder Polyisocyanate i) alle Verbindungen geeignet, die mindestens zwei zur Reaktion mit Alkoholen oder primären bzw. sekundären Aminen befähigte Isocyanatgruppen enthalten. Besonders bevorzugt werden Diisocyanato-diphenylmethan, Diisocyanatotoluol (= Toluylendiisocyanat), Hexamethylendiisocyanat und Isophorondiisocyanat, sowie deren Oligomere vom Isocyanurat- und Biuret-Typ.

Als Aminoverbindung ii) sind alle primären und sekundären Amine geeignet, die gegenüber Isocyanatgruppen reaktiv sind. Beispiele sind n-Butylamin, n-Pentylamin, n-Hexylamin, Dodecylamin, Benzylamin, Ethylhexylamin, Dibutylamin, Ethylisopropylamin, 1-Methoxy-2-aminopropan, Dibenzylamin, 1,5-Dimethylhexylamin, Dipentylamin, Dihexylamin, Cyclopropylamin, Cyclopentylamin, Methylbenzylamin, sowie deren Gemische.

Besonders geeignet sind Amine der allgemeinen Formel

$R'HN-R-XH$ (I)

und/oder

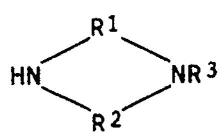 , (II),

wobei in der allgemeinen Formel (I)

$R'HN-R-XH$ (I)

R für den zweiwertigen Rest eines, gegebenenfalls substituierten, Alkans, beispielsweise mit 2 bis 10 Kohlenstoffatomen, wie $-(CH_2)_p-$mit p = 2 bis 10, $-CH_2-C(CH_3)_2-CH_2-$ oder $-CH(CH_3)-CH_2-$, eines Arens, beispielsweise Phenylen, eines substituierten Arens, beispielsweise $-(CH_2)_r-C_6H_3(OH)-$ mit r = 1 bis 6, vorzugsweise 2, eines Ethers, beispielsweise $-(CH_2-CHR^{IV}-O)_q-CH_2-CHR^{IV}$ mit q = 1 bis 5, und $R^{IV}$ = H oder Alkyl mit 1 bis 4 Kohlenstoffatomen, eines Amins, beispielsweise mit 2 bis 20 Kohlenstoffatomen, wie z. B. $-(CH_2)_3-N(CH_3)-(CH_2)_3-$, eines Polyamins, beispielsweise $-(CH_2-CH_2-NH)_o-$ mit o = 2 bis 5, eines Esters, beispielsweise mit 4 bis 20 Kohlenstoffatomen, wie z. B. $-(CH_2)_2-COO-(CH_2)_s-$ mit s = 2 bis 6, $-CH_2-COO-CH_2-CH(CH_3)-$, oder eines Amids, beispielsweise mit 4 bis 20 Kohlenstoffatomen, wie z.B. --$(CH_2)_2-CONH-CH_2-$ oder $-(CH_2)_2-CONH-(CH_2)_5-NHOC-(CH_2)_2-$;

$R'$ für wasserstoff, Alkyl, beispielsweise mit 1 bis 30, vorzugsweise 1 bis 10 Kohlenstoffatomen, wie z.B. Methyl, Ethyl, Propyl, Butyl sowie Isomere davon, Cyclohexyl, Aryl, beispielsweise mit 6 bis 18 Kohlenstoffatomen, vorzugsweise Phenyl, Naphthyl,

Aralkyl, beispielsweise mit 7 bis 20 Kohlenstoffatomen, z.B. Benzyl, 1-Phenylethyl, 1-Methyl-3-phenylpropyl, Hydroxyalkyl, beispielsweise mit 2 bis 10 Kohlenstoffatomen, wie z. B. Hydroxyethyl, Hydroxypropyl, Hydroxybutyl,

Aminoalkyl, beispielsweise mit 2 bis 10 Kohlenstoffatomen, wie z. B. Aminoethyl, Aminopropyl, Dimethylaminobutyl, Dimethylaminoneopentyl, Mercaptoalkyl, beispielsweise mit 2 bis 10 Kohlenstoffatomen, wie z. B. Mercaptoethyl oder Derivate dieser Gruppen, wie z.B. Alkyl-, Aryl-, Halogen-, Carboxyl-, Nitro-, Nitril-, Sulfoxyl-, Amino-, Alkoxy-, Aryloxy-substituierte Derivate, oder den einwertigen Rest $H\{O-(CH_2)_n-CHR''\}_m$ mit n = 1 bis 3 und m = 1 bis 10 oder Isomere dieses Rests und $R''$ = H oder $C_1$- bis $C_4$-Alkyl, wie er durch einfache Addition bzw. Polyaddition von cyclischen Ethern, z. B. Ethylenoxid, Propylenoxid oder Tetrahydrofuran erhältlich ist, z. B. Hydroxyethyloxyethyl;

X für O, S oder $NR'''$, worin $R'''$ für Wasserstoff, Alkyl, beispielsweise mit 1 bis 10 Kohlenstoffatomen, wie z.B. Methyl oder Ethyl, Aryl, beispielsweise Phenyl oder Naphthyl, Aralkyl, beispielsweise Benzyl oder

Phenylethyl, Hydroxyalkyl, Aminoalkyl oder Mercaptoalkyl, wobei deren Alkylgruppen jeweils 1 bis 10 Kohlenstoffatome enthalten können, oder Derivate dieser Gruppen der unter $R'$ genannten Art steht.

Beispiele für Verbindungen der allgemeinen Formel $R'HN-R-XH$ sind Ethylendiamin, Butandiamin, Neopentandiamin, Polyoxypropylendiamine, Polyoxyethylendiamine, N-Ethylethylendiamin, Diethylentriamin, Monoisopropanolamin. Besonders bevorzugt werden Ethanolamin, Diethanolamin, Diisopropanolamin, Neopentanolamin, Ethylisopropanolamin, Butylethanolamin und 2-Mercaptoethylamin.

In der allgemeinen Formel (II)

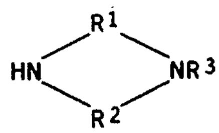 (II),

können $R^1$ und $R^2$ untereinander gleich oder verschieden sein und insbesondere den zweiwertigen Rest eines, gegebenenfalls substituierten, Alkans, beispielsweise mit 2 bis 4 Kohlenstoffatomen, z. B. $-(CH_2)_t-$ mit $t = 1$ bis 4, Arens, beispielsweise o-Phenylen, Ethers, beispielsweise mit 2 bis 4 Kohlenstoffatomen, z. B. $-CH_2-O-CH_2-$bedeuten;

$R^3$ kann für Wasserstoff, Alkyl, Aryl, Aralkyl, Hydroxyalkyl, Aminoalkyl, Mercaptoalkyl oder deren Derivate der unter $R'$ genannten Art stehen. Bevorzugte Verbindungen der allgemeinen Formel

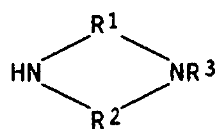 (II),

sind Piperazin und 1-(2-Hydroxyethyl)piperazin.

Desgleichen eignen sich auch Gemische der unter ii) genannten Aminoverbindungen, wobei deren Umsetzung mit Isocyanat gleichzeitig oder in beliebiger Reihenfolge stufenweise erfolgen kann. Bevorzugte Kombinationen bestehen aus Aminen der allgemeinen Formeln (I) und/oder (II) und primären oder sekundären Aminen. Besonders bevorzugte Kombinationen sind Hydroxyalkylaminoverbindungen, wie z.B. Diisopropanolamin, Diethanolamin, Ethanolamin mit primären oder sekundären aliphatischen Aminen, wie z.B. Butylamin und Dibutylamin.

Als gegebenenfalls mitzuverwendende Verbindungen mit mindestens einer Hydroxyfunktion iii) sind alle mono-und multifunktionellen Alkohole geeignet, die gegenüber Isocyanatgruppen reaktiv sind. Beispiele sind Mono-, Di- und Trialkohole mit 1 bis 20 Kohlenstoffatomen, wie Methanol Ethanol, n-Propanol, Isopropanol, Butanol, 1-Methoxybutanol, Ethylenglykol, Propylenglykol, Butandiol, Hexandiol, Cyclohexandimethanol, Glycerin, Trimethylolpropan etc. Bevorzugt werden aliphatische Alkohole mit 1 bis 6 Kohlenstoffatomen.

(b) Als organische Verbindungen, die eine oder mehrere Carboxylgruppen enthalten, kommen niedermolekulare Carbonsäuren in Frage, wie z.B. 1 bis 20 Kohlenstoffatome enthaltende Monocarbonsäuren oder Dicarbonsäuren wie Adipinsäure, Phthalsäure, Terephthalsäure, Malonsäure, Bernsteinsäure oder Maleinsäure. Besonders geeignet als Komponente (b) sind carboxylgruppenhaltige Verbindungen, die aufgrund ihrer Zusammensetzung und ihres Molekulargewichts über gute Filmbildungseigenschaften verfügen. Bevorzugt werden Polymere mit einem mittleren Molekulargewicht $\overline{M}_n$ über 10.000, vorzugsweise zwischen 15.000 und 300.000 und einer Säurezahl, die zwischen 50 und 300 mg KOH/g liegt. Besonders bevorzugt sind Copolymere aus einem sauren Monomer, wie z.B. Acrylsäure, Methacrylsäure, Crotonsäure oder Itaconsäure und einem oder mehreren hydrophoben Comonomeren, z.B. Styrol, Ethylacrylat, Butylacrylat, 2-Ethylhexylacrylat oder Methylmethacrylat. Besonders geeignet sind auch Styrol-Maleinsäureanhydrid-Copolymere, die mit niederen Alkoholen teilweise verestert sind. Die Zusammensetzung dieser Copolymeren wird so gewählt, daß sie mit der Komponente (a) verträglich sind.

Das Mengenverhältnis von Komponente (b) zu Komponente (a) wird so gewählt, daß die erfindungsgemäßen strahlungsempfindlichen Gemische in der verwendeten Entwicklerlösung unlöslich sind, jedoch bei Belichtung löslich werden. Der Konzentrationsbereich, in dem dies erreicht wird, hängt naturgemäß stark von der Zusammensetzung der Komponente (b) ab. Im allgemeinen hat sich für die Komponente (b) eine Konzentration von 5 bis 40 Gew.-%, besonders bevorzugt von 10 bis 30 Gew.-%, bezogen auf das

Gesamtgewicht des strahlungsempfindlichen Gemisches, als günstig erwiesen.

(c) Als ein- oder mehrfach ethylenisch ungesättigte Verbindungen eignen sich niedermolekulare oder oligomere Verbindungen mit mindestens einer ethylenisch ungesättigten Doppelbindung. Die Verbindungen werden so gewählt, daß sie mit den übrigen Bestandteilen des erfindungsgemäßen strahlungsempfindlichen Gemisches verträglich sind. Bevorzugt werden $\alpha,\beta$-ungesättigte Carbonylverbindungen. Besonders bevorzugt werden Acrylate und Methacrylate, wie z.B. Alkyl(meth)acrylate, Alkyl- oder Arylpolyethylenglykol-(meth)acrylate mit 2 bis 10 Ethylenglykol-Einheiten, Alkyl- oder Arylpolypropylenglykol(meth)acrylate mit 2 bis 10 Propylenglykoleinheiten, Polyethylenglykoldi(meth)acrylate mit 2 bis 10 Ethylenglykol-Einheiten, Polypropylenglykoldi(meth)acrylate mit 2 bis 10 Propylenglykol-Einheiten oder Umsetzungsprodukte von Bisphenol-A, Epichlorhydrin und (Meth)acrylsäure. Die ethylenisch ungesättigten Verbindungen (c) werden dem strahlungsempfindlichen Gemisch bevorzugt in einer Konzentration von 1 bis 40 Gew.-%, besonders bevorzugt von 3 bis 25 Gew.-%, bezogen auf das Gesamtgewicht des strahlungsempfindlichen Gemisches, zugesetzt. Eine hohe Konzentration, d.h. mehr als 15 Gew.-% wird man insbesondere dann wählen, wenn man nach einem ersten Belichtungsschritt und der Entfernung des belichteten Materials in einer Entwicklerlösung in einem zweiten, längeren Belichtungsschritt eine Vernetzung herbeiführen will, um so die mechanische Stabilität, z.B. bei Druckplatten zu verbessern.

Es ist ferner auch möglich, die Komponenten (b) und (c) in einer Verbindung zu kombinieren, d.h. eine carboxylgruppenhaltige ethylenisch ungesättigte Verbindung zu verwenden. Beispiele für solche Verbindungen sind Fumarsäure, Maleinsäure, (Meth)acrylsäure oder Umsetzungsprodukte von Hydroxygruppen enthaltenden Acrylaten, z.B. $\beta$-Hydroxyalkylacrylaten wie sie durch Umsetzung von Epoxiverbindungen mit Acrylsäure oder unvollständige Veresterung von Di- und Polyalkoholen mit Acrylsäure erhalten werden, bzw. von hydroxyfunktionalisierten Urethanacrylaten, erhalten durch Umsetzung eines Überschusses von Di- oder Polyalkoholen mit Isocyanatverbindungen, mit Säureanhydriden wie z.B. Maleinsäure- oder Phthalsäureanhydrid. Bevorzugt werden auch hier polymere Verbindungen eingesetzt, die aufgrund ihres Molekulargewichts gute Filmbildungseigenschaften aufweisen. Solche polymeren Verbindungen, die sowohl Carboxylgruppen als auch ethylenisch ungesättigte Gruppen enthalten, können beispielsweise aus den oben als Komponente (b) erwähnten Copolymeren aus Styrol, (Meth)acrylat und (Meth)acrylsäure durch Umsetzung mit Glycidylacrylat oder -methacrylat erhalten werden. Dabei wird man die Reaktion bevorzugt so führen, daß 5 bis 40 % der freien Carboxylgruppen des Copolymeren umgesetzt werden.

Eine andere Möglichkeit, Polymere mit Carboxylgruppen und ethylenisch ungesättigten Gruppen herzustellen, besteht darin, zusätzlich zu den bereits erwähnten Comonomeren, Hydroxalkyl(meth)acrylate einzupolymerisieren und die Hydroxygruppen in einem zweiten Schritt mit Anhydriden ungesättigter Carbonsäuren, z.B. Maleinsäureanhydrid oder Methacrylsäureanhydrid, umzusetzen. Selbstverständlich sind dem Fachmann noch weitere Verfahren zur Herstellung der genannten Polymeren geläufig. Die genannten Verbindungen, die sowohl Carboxylgruppen als auch ethylenisch ungesättigte Gruppen enthalten, werden bevorzugt in einer Konzentration von 5 bis 60 Gew.-%, besonders bevorzugt von 10 bis 40 Gew.-%, bezogen auf das Gesamtgewicht des strahlungsempfindlichen Gemisches, eingesetzt.

(d) Als gegebenenfalls mitzuverwendende Photoinitiatoren für das erfindungsgemäße strahlungsempfindliche Gemisch kommen die für lichtempfindliche, photopolymerisierbare Aufzeichnungsmaterialien üblichen und an sich bekannten Photoinitiatoren bzw. Photoinitiatorsysteme in Betracht. Beispielhaft seien hierfür genannt: Benzoin, Benzoinether, insbesondere Benzoinalkylether, substituierte Benzoine, Alkylether von substituierten Benzoinen, wie z. B. $\alpha$-Methylbenzoinalkylether oder $\alpha$-Hydroxymethylbenzoinalkylether; Benzile, Benzilketale, insbesondere Benzildimethylketal, Benzilmethylethylketal oder Benzilmethylbenzylketal; die als Photoinitiator bekannten und wirksamen Acylphosphinoxid-Verbindungen, wie z. B. 2,4,6-Trimethylbenzoyldiarylphosphinoxid; Benzophenon, Derivate des Benzophenons, 4,4'-Dimethylaminobenzophenon, Derivate von Michler's Keton; Anthrachinon und substituierte Anthrachinone; arylsubstituierte Imidazole oder deren Derivate, wie z. B. 2,4,5-Triarylimidazoldimere; Thioxanthonderivate, die als Photoinitiatoren wirksamen Acridin- oder Phenacin- Derivate und N-Alkoxypyridiniumsalze und deren Derivate. Geeignete Photoinitiatoren sind auch Diazoniumsalze, wie z. B. p-Phenylaminobenzoldiazonium-hexafluorophosphat, Iodoniumsalze, wie z. B. Diphenyliodoniumtetrafluoroborat, oder Sulfoniumsalze, wie z. B. Triphenylsulfoniumhexafluoroarsenat. Beispiele für Initiatorsysteme sind Kombinationen der genannten Initiatoren mit Sensibilisierungshilfsmitteln oder Aktivatoren, wie insbesondere tertiären Aminen. Typische Beispiele für solche Initiatorsysteme sind Kombinationen aus Benzophenon oder Benzophenon-Derivaten mit tertiären Aminen, wie Triethanolamin oder Michler's Keton; oder Gemische aus 2,4,5-Triarylimidazol-Dimeren und Michler's Keton oder den Leukobasen von Triphenylmethanfarbstoffen. Die Auswahl der geeigneten Photoinitiatoren bzw. Photoinitiator-Systeme ist dem Fachmann geläufig. Besonders bevorzugte Photoinitiatoren sind Michlers Keton, Benzophenon, Hexaarylbisimidazol-Derivate und N-Alkoxypyridinium-Salze. Auch Mischungen der genannten Photoinitiatoren eignen sich sehr gut. Die Photoinitiatoren bzw.

Photoinitiatorsysteme sind in der lichtempfindlichen Aufzeichnungsschicht im allgemeinen in Mengen von 0,1 bis 10 Gew.-%, bezogen auf das strahlungsempfindliche Gemisch, enthalten.

(e) Als weitere Zusatz- und/oder Hilfsstoffe (e), die in dem erfindungsgemäßen strahlungsempfindlichen Gemisch enthalten sein können, kommen z. B. Farbstoffe und/oder Pigmente, photochrome Verbindungen bzw. Systeme, sensitometrische Regler, Weichmacher, Verlaufshilfsmittel, Mattierungs-oder Gleitmittel oder basische Komponenten und dergleichen in Betracht. Beispiele für Farbstoffe und/oder Pigmente, die sowohl als Kontrastmittel als auch schichtverfestigend wirken können, sind u.a. Brilliant Green Dye (C.I. 42 040), Viktoria-Reinblau FGA, Viktoria-Reinblau 80 (C.I. 42 595), Viktoria-Blau B (C.I. 44 045), Rhodamin 6 G (C.I. 45 160), Triphenylmethanfarbstoffe, Naphthalimidfarbstoffe und 3′-Phenyl-7-dimethylamino-2,2′-spiro-di-(2H-1-benzopyran). Photochrome oder Farbumschlag-Systeme, die bei Belichtung mit aktinischem Licht reversibel oder irreversibel ihre Farbe ändern, ohne hierbei den Photopolymerisationsprozeß zu stören, sind z. B. Leukofarbstoffe zusammen mit geeigneten Aktivatoren. Als Beispiele für Leukofarbstoffe seien die Leukobasen der Triphenylmethanfarbstoffe, wie Kristallviolett-Leukobase und Malachitgrün-Leukobase, Leuko-Basischblau, Leuko-Pararosanilin, Leuko-Patentblau A oder V genannt; ferner kommt auch Rhodamin B-Base in Betracht. Als Aktivatoren für diese photochromen Verbindungen kommen u.a. organische Halogenverbindungen, die bei Belichtung mit aktinischem Licht Halogenradikale abspalten, oder Hexaarylbisimidazole in Betracht. Geeignete Farbumschlagsysteme sind auch in DE-A-38 24 551 beschrieben. Besonders geeignete Farbumschlagsysteme sind solche, bei denen die Farbintensität bei Belichtung geringer wird, wie z. B. Sudanfarbstoffe, Polymethinfarbstoffe oder Azofarbstoffe in Kombination mit geeigneten Photoinitiatoren. Zu den sensitometrischen Reglern gehören Verbindungen wie z. B. 9-Nitroanthracen, 10,10′-Bisanthron, Phenazinium-, Phenoxazinium-, Acridinium- oder Phenothiazinium-Farbstoffe, insbesondere in Kombination mit milden Reduktionsmitteln, 1,3-Dinitrobenzole und ähnliche. Als Weichmacher können die an sich bekannten und üblichen niedermolekularen oder hochmolekularen Ester, wie Phthalate oder Adipate, Toluolsulfonamid oder Tricresylphosphat, dienen. Als basische Komponenten kommen Zusätze von Aminen, insbesondere tertiären Aminen, z.B. Triethylamin oder Triethanolamin, oder Alkali- und Erdalkalihydroxide und -carbonate in Betracht. Die Zusatz- und/oder Hilfsstoffe sind im strahlungsempfindlichen Gemisch in den für diese Stoffe üblichen und bekannten wirksamen Mengen vorhanden. Ihre Menge sollte jedoch im allgemeinen 30 Gew.-%, vorzugsweise 20 Gew.-%, bezogen auf das strahlungsempfindliche Gemisch, nicht überschreiten.

Eine Folie oder Beschichtung kann aus dem erfindungsgemäßen Gemisch hergestellt werden, indem die oben beschriebenen Verbindungen in einem Lösemittel gelöst werden, und die erhaltene Lösung dann durch Gießen, ggf. mit Hilfe eines Rakels, Aufschleudern, Roller-Coating oder andere Auftragsverfahren auf einen permanenten oder temporären Träger aufgebracht wird.

Geeignete Lösemittel sind z. B. aromatische Kohlenwasserstoffe, niedermolekulare Ketone, Alkohole, Ether, Ester und Chlorkohlenwasserstoffe.

Als Träger für die erfindungsgemäßen lichtempfindlichen Beschichtungen kann praktisch jedes auf dem Drucksektor und bei der Herstellung von Leiterplatten für die Elektronikindustrie gebräuchliche Material eingesetzt werden. Eine wichtige Bedingung ist jedoch, daß der Träger inert ist, d.h. nicht mit dem zur Herstellung der Beschichtung verwendeten lichtempfindlichem Gemisch reagiert.

Solche Trägermaterialien sind z. B. Stahl, Aluminiumlegierungen, mechanisch, chemisch oder elektrochemisch aufgerauhtes Aluminium, Silicium, Polyester und andere Kunststoffe. Die Schichtdicke kann dabei in weiten Grenzen variieren. Sie wird z. B. bei der Verwendung des strahlungsempfindlichen Gemisches als Hochdruck- oder Tiefdruckplatte typischerweise zwischen 50 und 500 µm, bei der Verwendung als Photoresist für die Herstellung gedruckter Schaltungen zwischen 20 und 100 µm und bei der Verwendung als Photoresist zur Strukturierung von Halbleitermaterialien zwischen 0,3 und 5 µm betragen. Wird das erfindungsgemäße strahlungsempfindliche Gemisch als Offsetdruckplatte verwendet, wird man die Beschichtung so vornehmen, daß Trockenschichtgewichte von 0,5 - 5 g/qm erhalten werden.

Die erfindungsgemäßen strahlungsempfindlichen Gemische eignen sich in vorteilhafter Weise für die Herstellung von Druckformen oder Resistmustern nach den hierfür an sich bekannten und üblichen Verfahren. Hierzu wird die lichtempfindliche Aufzeichnungsschicht - bei Photoresistfilmen und Schichtübertragungsmaterialien nach der Schichtübertragung auf das zu schützende Substrat - bildmäßig mit aktinischem Licht belichtet, wobei sich hierfür die üblichen Lichtquellen von aktinischem Licht, wie beispielsweise UV-Fluoreszenzröhren, Quecksilberhoch-, -mittel- oder -niederdruckstrahler, superaktinische Leuchtstoffröhren, Xenon-Impulslampen, aber auch UV-Laser, Argonlaser und ähnliche, eignen. Die von den Lichtquellen emittierte Wellenlänge soll im allgemeinen zwischen 230 und 450 nm, bevorzugt zwischen 300 und 420 nm, liegen und insbesondere auf die Eigenabsorption des in der photopolymerisierbaren Aufzeichnungsschicht enthaltenen Photoinitiators abgestimmt sein.

Nach der bildmäßigen Belichtung wird die Druckform bzw. das Resistmuster durch Auswaschen der

belichteten Bereiche der Aufzeichnungsschicht mit Wasser oder vorzugsweise einer wäßrig-alkalischen Entwicklerlösung entwickelt. Das Entwickeln kann durch Waschen, Sprühen, Reiben, Bürsten etc. erfolgen. Die erfindungsgemäßen Aufzeichnungselemente zeigen dabei einen großen Entwicklungsspielraum und eine sehr geringe Überwaschempfindlichkeit. Als Entwicklerlösungen kommen wäßrig-alkalische Lösungen in Betracht, die zur Einstellung des günstigsten pH-Wertes, im allgemeinen im Bereich von 8 bis 14, vorzugsweise im Bereich von etwa 9 bis 13, alkalisch reagierende Substanzen, wie z. B. Borax, Dinatriumhydrogenphosphat, Soda, Alkalihydroxide oder organische Basen, wie Di- oder Triethanolamin in Wasser gelöst, enthalten. Die wäßrig-alkalischen Entwicklerlösungen können auch Puffersalze, z. B. wasserlösliche Alkaliphosphate, -silikate, -borate, -acetate oder -benzoate enthalten. Als weitere Bestandteile der Entwicklerlösungen können Netzmittel, vorzugsweise anionische Netzmittel, und gegebenenfalls wasserlösliche Polymere, wie z. B. Natriumcarboxymethylcellulose, Polyvinylalkohol, Polynatriumacrylat und dergleichen, mitverwendet werden. Obwohl die erfindungsgemäßen Aufzeichnungselemente im allgemeinen mit Wasser bzw. wäßrig-alkalischen Entwicklerlösungen ausgewaschen werden, ist es selbstverständlich grundsätzlich möglich, wenn auch nicht erforderlich, daß die Entwicklerlösungen auch noch geringe Zusätze an wasserlöslichen organischen Lösungsmitteln, wie z. B. aliphatischen Alkoholen, Aceton oder Tetrahydrofuran, enthalten.

Die erfindungsgemäßen strahlungsempfindlichen Gemische können z. B. durch energiereiche Strahlung wie Elektronen- oder Röntgenstrahlung strukturiert werden, wobei sie sich durch eine sehr hohe Strahlungsempfindlichkeit auszeichnen. Bei dieser Verwendung kann man im allgemeinen auf den Zusatz eines eigenen Initiatorsystems verzichten. Will man die erfindungsgemäßen Gemische hingegen durch sichtbares oder UV-Licht strukturieren, wie es bei der Herstellung von Druckplatten und Photoresisten üblich ist, wird man geeignete Photoinitiatoren zusetzen, deren spektrale Empfindlichkeit auf die Emission der verwendeten Lichtquelle abgestimmt ist. Auch diese Gemische zeichnen sich durch eine für positiv arbeitende Systeme sehr hohe Lichtempfindlichkeit aus, die der Lichtempfindlichkeit handelsüblicher Negativsysteme vergleichbarer Schichtdicke entspricht. Diese hohe Lichtempfindlichkeit wird erreicht, ohne daß zusätzliche Verfahrensschritte z. B. die bei vielen anderen Positivsystemen notwendige thermische Nachbehandlung erforderlich wären. Auch die eingesetzten Entwicklerlösungen entsprechen den bei negativ arbeitenden Schichten eingesetzten, so daß vollkommene Kompatibilität der erfindungsgemäßen Aufzeichnungsschichten mit herkömmlichen Systemen besteht. Die erfindungsgemäßen strahlungsempfindlichen Aufzeichnungsschichten eignen sich gut für Mehrfachbelichtungen. Dadurch können bei vielen Anwendungen Verfahrensschritte eingespart werden. Mehrfachbelichtungen sind bei allen photopolymerisierbaren Systemen, aber auch bei vielen Positivsystemen aus prinzipiellen Gründen nicht möglich. Die erfindungsgemäßen strahlungsempfindlichen Gemische weisen weiter die interessante Eigenschaft auf, daß sie zwar bei kurzen Bestrahlungszeiten als Positivsysteme arbeiten, bei längeren Bestrahlungszeiten jedoch als vernetzbare Systeme angesehen werden können. Dieser Effekt tritt insbesondere dann auf, wenn in dem strahlungsempfindlichen Gemisch die ein- oder mehrfach ethylenisch ungesättigten Verbindungen c) in einer Menge von >15 Gew.-% vorhanden sind. Diese Eigenschaft kann ausgenützt werden, um nach einem ersten, bildmäßigen Belichtungsschritt mit kurzer Belichtungszeit und nach Entfernung der belichteten Bereiche in einer Entwicklerlösung in einem zweiten, nicht notwendigerweise bildmäßigen Belichtungsschritt mit deutlich höherer Belichtungszeit eine Vernetzung auszulösen. Auf diese Weise können die mechanischen Eigenschaften, z. B. von Druckplatten, verbessert werden.

Die Erfindung wird durch die nachstehenden Beispiele näher erläutert.

Die in den Herstellvorschriften und Beispielen genannten Teile und Prozente sind, soweit nicht anders angegeben, Gewichtsteile bzw. Gewichtsprozente.

Herstellung der erfindungsgemäß einzusetzenden Umsetzungsprodukte (a)

Herstellvorschrift

In eine Vorlage mit 266,4 g Isophorondiisocyanat (1,2 Mol) und 251 g Methylethylketon werden innerhalb 30 Minuten bei 16 bis 18 °C unter Eiskühlung 154,8 g Di-n-Butylamin (1,2 mol) zugetropft. Nach einer Reaktionszeit von 30 Minuten bei einer max. Temperatur von 46 °C werden 150,4 g Diisopropanolamin (1,13 mol) bei 46 °C in 20 Minuten zugetropft. Dabei steigt die Temperatur auf 50 °C. Die Reaktion ist nach 4 Stunden bei 50 °C beendet. Die 67,8 %ige Lösung hat eine Viskosität von 500 mPa•s (gemessen bei 23 °C mit einem Kegel/Platte-Viskosimeter).

Beispiel 1

7 g des nach obiger Herstellvorschrift hergestellten Umsetzungsprodukts, 2,5 g eines Copolymeren aus Styrol (25 %), Methylmethacrylat (35 %), Butylacrylat (10 %) und Methyacrylsäure (30 %) mit einem K-Wert (nach H. Fikentscher) von 41, 0,5 g Tripropylenglykoldiacrylat, 700 mg N-Methoxypicolinium-tosylat und 15 mg Michler's Keton wurden in 8 g Methylethylketon gelöst und so auf eine 23 µm starke Polyethylenterephthalatfolie gegossen, daß die photoempfindliche Schicht nach dem Trocknen eine Stärke von 40 µm aufwies. Die Schicht wurde zur Aufbewahrung mit einer 30 µm starken PE-Folie abgedeckt. Zur Prüfung wurde die PE-Folie abgezogen, der Verbund aus Polyethylenterephthalatfolie und photoempfindlicher Schicht mit der photoempfindlichen Schicht zum Kupfer auf ein kupferkaschiertes Leiterplattensubstrat laminiert und auf einem Riston®-PC-Printer mit 20 mJ/cm$^2$ belichtet. Nach dem Abziehen der Polyethylenterephthalatfolie wurde in einem Sprühwascher 150 Sekunden mit 1 %iger Sodalösung von 30 °C entwikkelt, wobei sich die belichteten Teile der lichtempfindlichen Schicht vollkommen entfernen ließen. Die unbelichteten Teile blieben unverändert.

Die Vergleichsbeispiele 1 und 2 zeigen, daß alle 3 Komponenten für die Auslösung des beobachteten Positiveffekts nötig sind.

Vergleichsbeispiel 1

Beispiel 1 wurde mit 7,5 g des nach obiger Herstellvorschrift erhaltenen umsetzungsprodukts und 2,5 g des dort beschriebenen Copolymeren wiederholt, d.h. es wurde auf den Zusatz der ethylenisch ungesättigten Verbindung verzichtet. Nach der in Analogie zu Beispiel 1 erfolgten Aufarbeitung und Belichtung ließen sich innerhalb von 5 Minuten weder belichtete noch unbelichtete Teile des Resists entfernen. Auch wenn die Belichtungsdosis bis auf 500 mJ/cm$^2$ erhöht wurde, wurde keine Löslichkeit der belichteten Teile beobachtet.

Vergleichsbeispiel 2

Beispiel 1 wurde unter Verwendung von 9,5 g des nach obiger Herstellvorschrift erhaltenen Umsetzungsprodukts und 0,5 g Tripropylenglykoldiacrylat wiederholt, d.h. dieses Mal wurde auf den Zusatz einer Verbindung mit Carboxylgruppen verzichtet. Die Aufarbeitung und Prüfung erfolgte wie in Beispiel 1 bzw. 2. Auch hier waren nach Belichtung mit 5 bis 500 mJ/cm$^2$ weder die belichteten noch die unbelichteten Teile des Resists löslich.

Beispiel 2

Analog zu Beispiel 1 wurden 6,7 g der nach obiger Herstellvorschrift hergestellten Verbindung, 3 g eines Copoylmeren aus Methylmethacrylat (57 %), Ethylacrylat (20 %) und Methacrylsäure (23 %) mit einem K-Wert (nach H. Fikentscher) von 44 und 0,3 g Tripropylenglykoldiacrylat in 8 g Methylethylketon mit 700 mg N-Methoxypicolinium-tosylat und 15 mg Michler's Keton versetzt. Die erhaltene Lösung wurde wie in Beispiel 1 weiterverarbeitet. Nach Belichtung in einem Riston®-PC-Printer mit 35 mJ/cm$^2$ ließen sich die belichteten Stellen in 90 Sekunden mit 1 %iger Sodalösung entwickeln. Die unbelichteten Stellen blieben unverändert.

Beispiel 3 und 4

Beispiel 1 wurde wiederholt, jedoch wurde Tripropylenglykoldiacrylat durch Bisphenol-A-Diglycidyletherdiacrylat bzw. Methylpolyglykolacrylat mit einer mittleren Kettenlänge von 15 Ethylenglykoleinheiten ersetzt. Die Aufarbeitung und Prüfung erfolgte analog zu Beispiel 1. Nach Belichtung mit 30 mJ/cm$^2$ betrugen die erforderlichen Entwicklungszeiten in 1 %iger Sodalösung 150 bzw. 110 Sekunden. Die unbelichteten Teile des Resists blieben bei Beispiel 3 unverändert, während sie bei Beispiel 4 leicht angequollen waren.

## Ansprüche

1. Strahlungsempfindliches Gemisch aus

(a) einem Harnstoffgruppen enthaltenden Umsetzungsprodukt,
(b) mindestens einer eine oder mehrere Carboxylgruppen enthaltenden organischen Verbindung,
(c) mindestens einer ein- oder mehrfach ethylenisch ungesättigten organischen Verbindung,
(d) gegebenenfalls einem Photoinititator oder Photoinitiatorsystem
sowie
(e) gegebenenfalls weiteren Hilfs- und Zusatzstoffen,
dadurch gekennzeichnet, daß als Komponente (a) ein Umsetzungsprodukt aus
i) mindestens einem Di- oder Polyisocyanat mit
ii) mindestens einer organischen Verbindung mit mindestens einer primären oder sekundären Aminogruppe und
iii) gegebenfalls einer oder mehreren Verbindungen mit mindestens einer Hydroxylgruppe,
wobei die Anzahl der NCO-Gruppen in i) kleiner oder gleich der Anzahl der damit reaktiven Gruppen in ii) und iii) ist,
eingesetzt wird.

2. Strahlungsempfindliches Gemisch nach Anspruch 1, dadurch gekennzeichnet, daß zur Herstellung des Harnstoffgruppen enthaltenden Umsetzungsproduktes (a) als Komponente i) ein Diisocyanat eingesetzt wurde.

3. Strahlungsempfindliches Gemisch nach Anspruch 1 oder 2, dadurch gekennzeichnet, daß zur Herstellung des Harnstoffgruppen enthaltenden Umsetzungsprodukts (a) als Komponente ii) ein oder mehrere primäre und/oder sekundäre Amine der allgemeinen Formel (I)

$R'HN-R-XH$ (I),

wobei
R den zweiwertigen Rest eines, gegebenenfalls substituierten, Alkans, Arens, Ethers, Polyethers, Amins, Polyamins, Esters, Polyesters, Amids oder Polyamids,
$R'$ Wasserstoff, Alkyl, Aryl, Aralkyl, Hydroxyalkyl, Aminoalkyl, Mercaptoalkyl, Derivate derselben oder den einwertigen Rest $H\{O-(CH_2)_n-CHR''\}_m$ mit $n = 1$ bis 3 und $m = 1$ bis 10 oder Isomere desselben und $R''$ = H oder $C_1$- bis $C_4$-Alkyl
X O, S oder $NR'''$,
$R'''$ Wasserstoff, Alkyl, Aryl, Aralkyl, Hydroxyalkyl, Aminoalkyl, Mercaptoalkyl oder Derivate derselben
bedeuten, und/oder
mindestens einer Aminoverbindung der allgemeinen Formel (II)

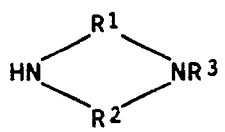

(II),

wobei
$R^1$ und $R^2$ untereinander gleich oder verschieden sind und den zweiwertigen Rest eines, gegebenenfalls substituierten, Alkans, Arens, Ethers, Polyethers, Amins, Polyamins, Esters, Polyesters, Amids oder Polyamids bedeuten,
$R^3$ Wasserstoff, Alkyl, Aryl, Aralkyl, Hydroxyalkyl, Aminoalkyl, Mercaptoalkyl oder Derivate derselben bedeutet,
eingesetzt wurden.

4. Strahlungsempfindliches Gemisch nach Anspruch 1, dadurch gekennzeichnet, daß zur Herstellung des Harnstoffgruppen enthaltenden Umsetzungsprodukts (a) als Komponente ii) eine Kombination aus wenigstens einem Amin gemäß Anspruch 3 und wenigstens einem weiteren davon verschiedenen primären oder sekundären Amin eingesetzt wurde.

5. Strahlungsempfindliches Gemisch nach einem der vorhergehenden Ansprüche, dadurch gekennzeichnet, daß zur Herstellung des Harnstoffgruppen enthaltenden Umsetzungsprodukts als Komponente iii) ein aliphatischer Monoalkohol eingesetzt wurde.

6. Strahlungsempfindliches Gemisch nach einem der vorhergehenden Ansprüche, dadurch gekennzeichnet, daß als Komponente (b) eine Carboxylgruppen enthaltende Verbindung mit einem mittleren Molekulargewicht $\overline{M}_n$ von über 10.000 verwendet wird.

7. Strahlungsempfindliches Gemisch nach einem der vorhergehenden Ansprüche, dadurch gekennzeichnet, daß als Komponente (b) eine Carboxylgruppen enthaltende Verbindung mit einer Säurezahl zwischen 50

und 300 verwendet wird.

8. Strahlungsempfindliches Gemisch nach einem der vorhergehenden Ansprüche, dadurch gekennzeichnet, daß als Komponente (b) ein Copolymer aus einem sauren Monomeren und mindestens einem hydrophoben Monomeren verwendet wird.

9. Strahlungsempfindliches Gemisch nach Anspruch 8, dadurch gekennzeichnet, daß als saures Monomer Acrylsäure, Methacrylsäure, Crotonsäure oder Itaconsäure verwendet wurde.

10. Strahlungsempfindliches Gemisch nach Anspruch 8 oder 9, dadurch gekennzeichnet, daß als hydrophobes Monomeres mindestens eines aus der Gruppe der Styrole, Acrylate oder Methacrylate verwendet wurde.

11. Strahlungsempfindliches Gemisch nach einem der vorhergehenden Ansprüche, dadurch gekennzeichnet, daß als ein- oder mehrfach ethylenisch ungesättigte Verbindung (c) eine $\alpha,\beta$-ethylenisch ungesättigte Carbonylverbindung eingesetzt wird.

12. Strahlungsempfindliches Gemisch nach einem der vorhergehenden Ansprüche, dadurch gekennzeichnet, daß als ethylenisch ungesättigte organische Verbindung (c) eine Acrylat oder Methacrylat verwendet wird.

13. Strahlungsempfindliches Gemisch nach Anspruch 1, dadurch gekennzeichnet, daß die Komponenten (b) und (c) identisch sind.

14. Strahlungsempfindliches Gemisch nach einem der vorhergehenden Ansprüche, dadurch gekennzeichnet, daß als Komponente (d) Benzophenon oder seine Derivate, Hexarylbisimidazolderivate, N-AlkoxypyridiniumSalze oder Gemische dieser Verbindungen verwendet werden.

15. Strahlungsempfindliches Gemisch nach einem der vorhergehenden Ansprüche, dadurch gekennzeichnet, daß seine Löslichkeit in Wasser oder wäßrig-alkalischer Lösung bei Bestrahlung zunimmt.